# EUROPEAN PATENT SPECIFICATION

(11) **EP 0 236 766 B1**
(45) Date of publication and mention of the grant of the patent: **20.01.1993**
(21) Application number: 87101863.6
(22) Date of filing: 11.02.1987
(51) Int. Cl.: H01L 49/02, B26F 1/04, B26D 5/08

(54) **Programmable magnetic repulsion punching apparatus**
Programmierbarer, mit magnetischer Abstossung arbeitender Stanzapparat
Appareil pour perforer par répulsion magnétique programmable

(30) Priority: 10.03.1986 US 837933
(43) Date of publication of application: 16.09.1987
(73) Proprietor: International Business Machines Corporation, Armonk, N.Y. 10504 (US)
(72) Inventor: Fleet, Russel Warrington, Walden N.Y. 12586 (US); Long, David Clifford, Wappingers Falls, N.Y. 12590 (US); Stroms, Karl Friedrich, Wappingers Falls, N.Y. 12590 (US); Weiss, Gerhard, LaGrangeville, N.Y. 12540 (US)
(74) Representative: Colas, Alain

(56) References cited:
- US-A- 3 730 039
- US-A- 4 425 829
- US-A- 4 538 493
- US-A- 4 596 359
- IBM TECHNICAL DISCLOSURE BULLETIN, vol. 20, no. 4, September 1977, New York COCHRAN, HAAS: "Automated Punch Apparatus for Forming Via Holes in a Ceramic Green Sheet" pages 1379, 1380

## Description

This invention relates to punch apparatus for punching very small holes in thin sheet material, more particularly, to a programmable punch for forming holes in sheet material such as green ceramic sheet.

In the manufacture of multilayer ceramic (MLC) substrates for integrated circuit semiconductor package structures, a plurality of green ceramic sheets is formed by doctor blading a slurry containing a resin binder, a particulate ceramic material, solvents, and a plasticizer, drying the doctor bladed sheet and cutting it into appropriate sized sheets. Via holes are then punched for forming electrical interconnections through the sheet. Electrically conductive paste is deposited in the holes, and in appropriate patterns on the surface of the sheets, the sheets stacked and laminated, and the assembly subsequently fired at a sintering temperature. Punching the via holes in ceramic sheets presents formidable engineering problems in view of their small size and density and the complex hole patterns needed. It is conventional to punch via holes with apparatus of the type disclosed in IBM Technical Disclosure Bulletin Vol. 13, No. 4, Feb. 13, 1971 P. 2536, or IBM TDB Vol. 16, No. 12, May 1974 P. 3933 and U.S.-A 4.425.829. In these apparatus a plurality of punch elements arranged in the grid on a punch head are indexed over the green sheet which is covered by interposer mask. The interposer mask contains openings where holes are desired to be punched. When the punch elements contact the interposer mask as the punch head is moved downwardly a hole will be punched where the openings occur since the punch element will pass through the openings in the interposer mask, and through ceramic green sheet. In other areas covered by the interposer mask, i.e. where holes are not desired, the interposer mask will cause the punch element to be retracted into the head.

Automated punch apparatus which utilize individually programmable punches have been suggested in IBM Technical Disclosure Bulletin Vol. 20 No. 4, Sept. 1977 P. 1379. This type of punching apparatus does not require the aforedescribed interposer mask, since the individual punching elements can be activated electrically upon command. In this apparatus, as in the punch apparatus that uses an interposer mask, a punch head is used which includes elements for each sector of the sheet to be punched. A punch head can have as many as 100 individual punch elements. In the programmable punch head, selected punches are extended with a solenoid and the entire head moved downwardly as a unit to punch the holes. The punches that have been moved into extended positions punch holes in the sheet. The others in retracted positions do not penetrate the sheets and therefor do not form holes. The support for the green sheet must stop during the punching stroke in order to avoid breaking the punch elements. In addition the general overall geometry of the hole pattern is dictated by the geometry of the punch head. the punch hole pattern cannot be conveniently expanded or contracted even though the hole pattern can be changed.

A high velocity punch that uses magneto repulsive actuator for driving a punch element through a workpiece is shown in US-A-3.730.039.

In accordance with the present invention, we provide improvements in punch apparatus for punching holes in sheet material, in particular a green ceramic sheet material.

The object of the invention is to provide an apparatus as defined in claim 1.

In the accompanying drawings forming a material part of this disclosure,
Fig. 1 is a prospective view of the overall apparatus of the invention illustrating the general relationship between the punch apparatus and the support for the sheet material.
Fig. 2 is a cross-sectional view in cross-section of the punch apparatus of the invention illustrating the elements thereof.
Fig. 3 is a top view taken on line 3-3 of Fig. 2.
Fig. 4 is a detailed view in broken section that illustrates a rotatable head for supporting the punch element which is a preferred alternate specific embodiment of the invention.
Fig. 5 is a sectional view taken on line 5-5 of Fig. 4.
Figs. 6A, 6B, 6C and 6D illustrate various embodiments of a feature of the coil of the invention.
Fig. 7 is an electrical circuit diagram of a circuit that can be used to actuate the punching apparatus of the invention.
Fig. 8 is a graph showing the relationship between the punch displacement and time.
Fig. 9 is schematic diagram of the control means for controlling the various elements of the punch apparatus of our invention.

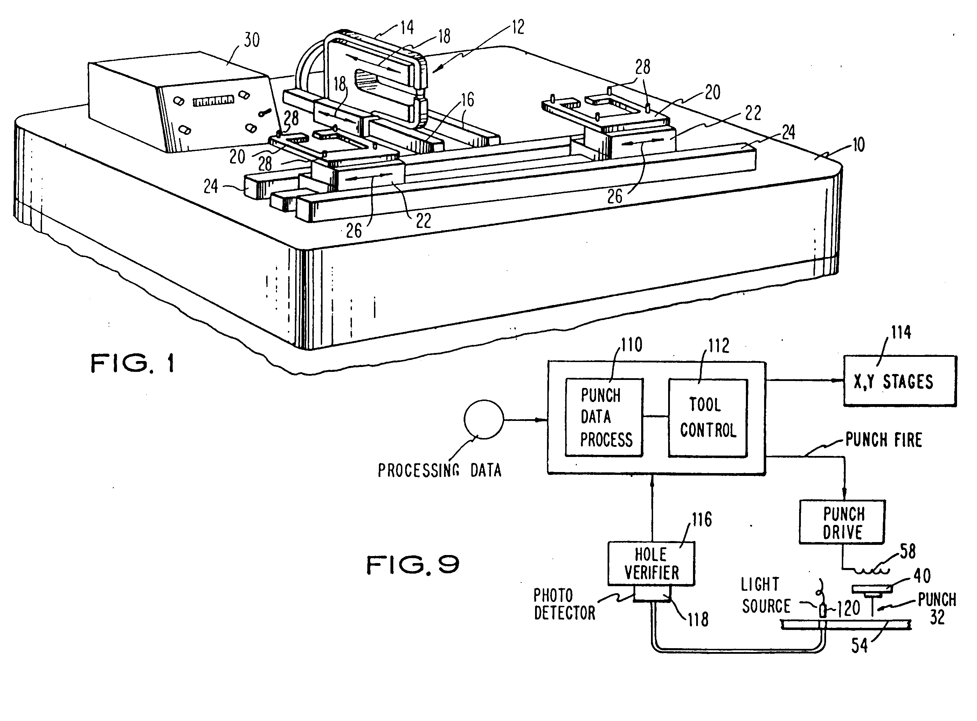

Referring now to the drawings, there is illustrated a punch apparatus of the invention. As shown in Fig. 1, a bench or table 10 supports the punch apparatus 12, which includes a punch assembly 14 mounted for movement on rail 16 in the direction indicated by arrow 18, and a sheet workpiece support mounted on carriage 22, in turn mounted on rails 24 for movement in the directions indicated by arrow 26. Preferably two sheet support elements 20 are provided, both of which are mounted for support on rails 24. suitable alignment pins 28 are provided on sheet support 20 to hold a sheet to be punched that is provided with alignment holes. The control panel 30 is provided with suitable controls to operate the punch apparatus 12.

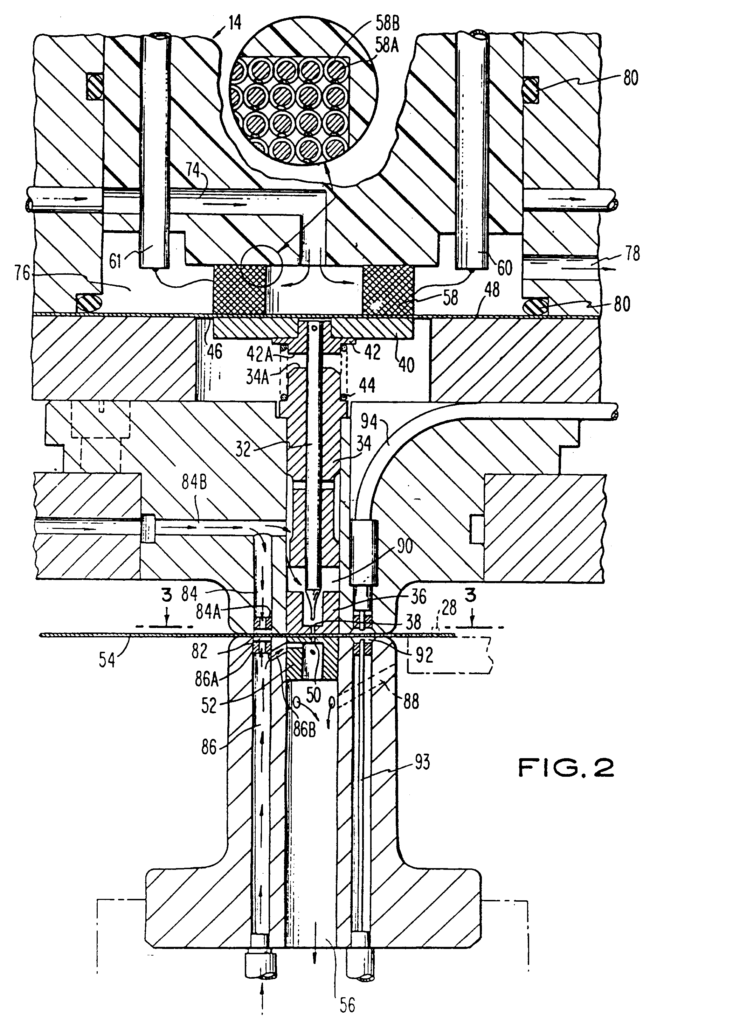

Referring to Fig. 2 of the drawings, there is illustrated the detailed structure of punch assembly 14. A punch element 32 is mounted for rectilinear movement on bushing 34 and punch guide block 36 which supports the end of the punch element, with the punch element end of reduced diameter aligned with hole 38 in block 36. The end of punch element 32 is withdrawn from hole 38 when it is in retracted position as indicated in Fig. 2. A planar element 40 of electrically conductive material is mounted on collar 42 in turn secured to the upper end of punch element 32. Spring 44 seated on abutment surfaces on bushing 34 and collar 42 support the weight of the punch element and attached elements to urge it into contact with an abutment surface 46 of sheet 48. The lower end of punch 32 is aligned with hole 50 in punch die 52. When the punch element 32 is actuated downwardly, the lower end will penetrate the workpiece sheet 54, form a hole, and the end of the punch enter hole 50 in punch die 52. The punched out material, i.e. the slug, will fall downwardly into chamber 56.

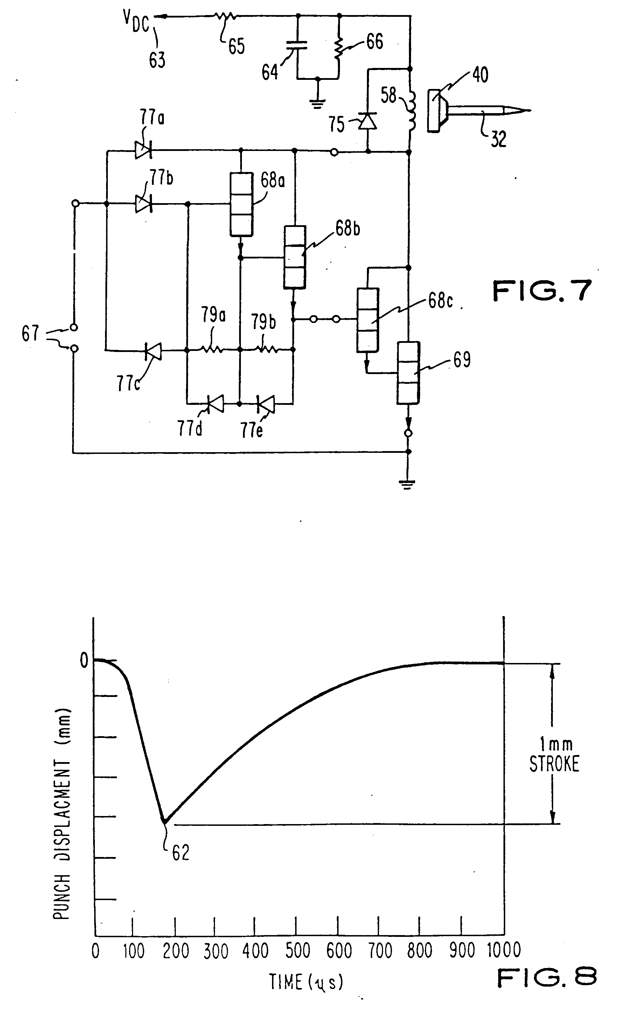

The punch element 32 is driven through the workpiece sheet 54 by magneto repulsion. A planar high energy coil 58 is mounted above plate 48 in close proximity to planar element 40. Leads 60 and 61 are connected to a suitable source of electric current. The current going through coil 58 produces a magnetic field that links with the planar disk 40 inducing a current that is substantially of opposite phase with the current flowing through the coil 58. This current in the disk 40 produces a magnetic field which opposes the field in coil 58. A force results from the two opposing magnetic fields which drives the disk 40 away from fixed coil 58. The force is proportional to the number of turns in coil 58, the time varying currents in the coil and disk as well as other physical parameters of the system. In the preferred embodiment a force of approximately 30 pounds is generated. This high force combined with a low moving mass yield a very high speed punch drive system. The movement of punch element 32 is terminated when the surface 42A of collar 42 strikes the surface 34A of bushing 34 and is rebounded. The pulse of electrical current passed through coil 58 is of a magnitude to produce a very rapid acceleration of the punch 32 away from coil 58. The punch displacement is indicated by the plot of punch displacement versus time in Fig. 8. The punch element 32, as indicated in Fig. 8, is very rapidly accelerated during the first 100 micro seconds. Thereafter for about another 100 micro seconds the velocity of the punch is constant, as indicated by the constant slope of the curve. The inflection point 62 indicates the point of rebound where the punch travels upwardly at only slightly less velocity. As the punch approaches the initial upward position, its velocity is markedly decreased. This dampening effect is produced by the air that is momentarily trapped between the planar element 40 and the flat surface 46. The spring 44 is provided solely to hold the planar element 40 against the surface 46. The high return velocity is achieved by the rebounding of collar 42 on bushing 34. The very high rebound velocity of the punch serves to eject the slug of material from the punch end. The inertia of the slug causes it to detach itself from the punch element and continue downwardly.

Referring now to Fig. 7 of the drawings, there is depicted a circuit suitable for actuating punch 32 by applying a current pulse to coil 58. An external DC power supply 63 typically 100V, charges the main energy storage capacitor 64 through resistor 65. Resistor 66 is a bleeder resistor to discharge capacitor 64 and is provided for safety reasons. A positive input drive signal from the control is applied across terminals 67 when a punch stroke is called for. The pulse signal is amplified by transistors 68A, 68B, and 68C, to turn on transistor 69 in turn connected to ground. This effectively connects drive coil 58 to capacitor 64. The current in coil 58 gradually increases to produce a punch stroke. The maximum current in the coil is determined by the coil and circuit DC resistance. By applying a negative drive signal across terminals 67, transistors 68A, 68B, 68C and 69 are turned off and the coil 58 effectively disconnected from capacitor 64. Disconnecting coil 58 from capacitor 64 causes the current in coil 58 to decay by flowing through diode 75. Diodes 77A, 77B, 77C, 77D and 77E, and resistors 79A and 79B are included in the circuit to insure a fast turn on and turn off of the associated transistors.

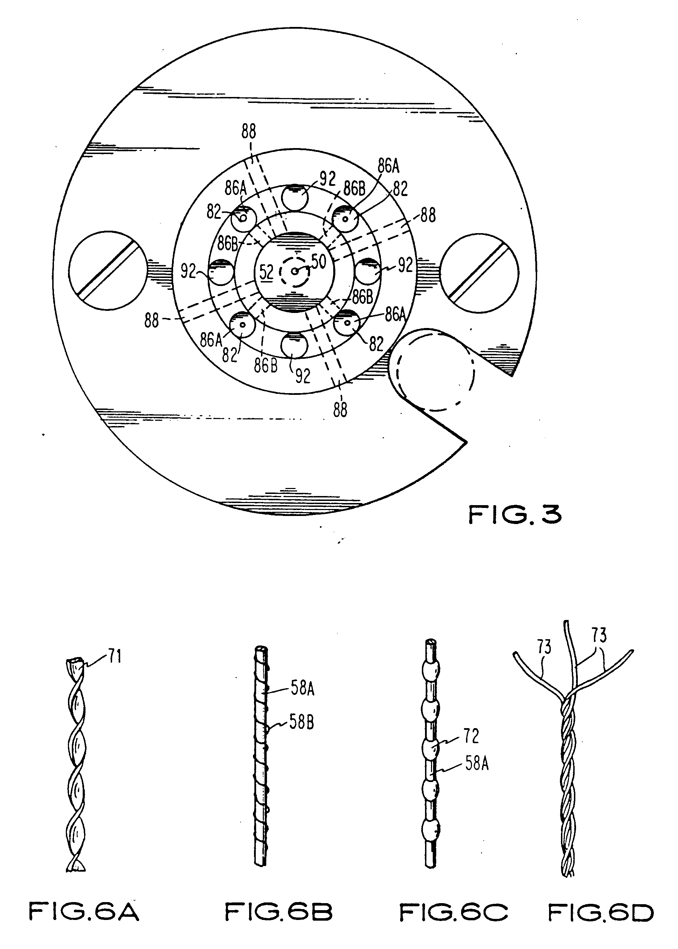

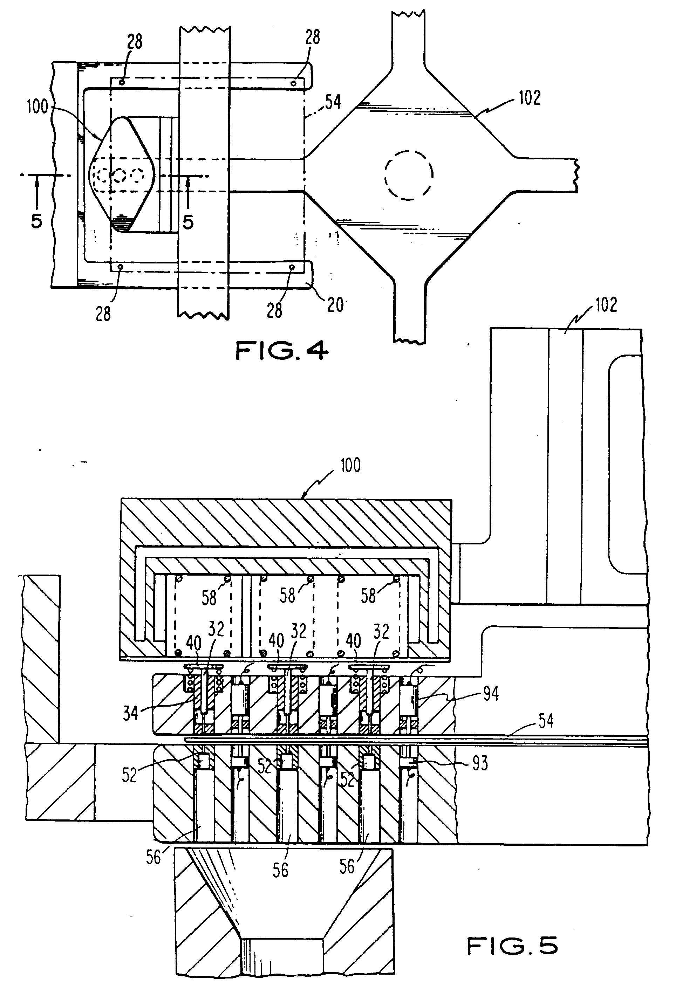

In order to achieve the high velocity of the punch element, a very large pulse of electrical current must be passed through the coil 58. This requires that it be cooled, normally by liquid cooling. In order to achieve the sufficient coolant flow, the windings 58A must be spaced by suitable spacers 58B, as indicated in the detailed drawing associated with Fig. 2. The spacing of the windings of coil 58 can be achieved by any of the structures shown in Figs. 6A through 6D. In the embodiment of Fig. 6A the winding 71 has a non-circular cross-section, for example a square or rectangular cross-section, and the winding twisted into a convoluted shape. When the winding is formed into a coil, the resulting coil is porous to circulating fluid. In the embodiment of Fig. 6B a line 58B of dielectric material, for example, nylon, is wound about the winding 58A, typically a copper wire to provide a spacing means. In the embodiment of Fig. 6C, spaced annular beads 72 of dielectric material are disposed about the winding 58A. In the embodiment of Fig. 6D a plurality of wires 73 are twisted or braided together to form a porous wire.

In a preferred structure for passing cooling fluid through coil 58, the liquid is passed radially through the windings. As shown in Fig. 2, an inlet passage 74 introduces cooling liquid to the center of coil 58. The pressure forces the liquid radially through the windings where it is collected in chamber 76 and exited out passage 78. Annular seals 80 are provided to prevent coolant leakage out of chamber 76.

In order to better support the workpiece sheet 54 over punch die 52, a plurality of air bearings 82 are provided around punch element 32, as indicated in Fig. 3. Each air bearing consists of air passages 84 and 86 with the ends thereof in aligned and opposed relation. Compressed air from the passages passed through bushings 84A and 86A respectively and are directed against opposite sides of workpiece sheet 54. A smaller branch air passage 86B connected to passage 86 directs air at the lower end of opening 50 in punch die 52 to assist in removing slugs of punched material from the punch element 32 upon completion of the punch stroke. Preferably a vacuum source is connected to chamber 56 to draw additional air through openings 88 to remove slugs of material and other debris.

An additional branch passage 84B in passage 84 is connected to chamber 90. By this arrangement, air is forced through opening 38 in bushing 34 and through the punch hole in sheet 54 following completion of the punch cycle. The air under pressure blows the slug of material that may have lodged in the die or sheet when the punch element was withdrawn.

In order to check for the presence or absence of punched holes in sheet 54, a plurality of hole sensors 92 are provided about the punch element 32 as indicated in Figs. 2 and 3. The hole sensor 92 consists of a pair of fiber optic cables 93 and 94 with the ends arranged in opposed and aligned relation on opposite sides of sheet 54. One of the cables i.e. 94, is connected to a light source, and the other cable 93 connected to a light sensor. When a hole in sheet 54 is aligned with the ends of fiber optic cables 93 and 94, the light sensor will detect light, and indicate the presence of a hole. When no hole exists, the light is blocked by the sheet which is also detectable by the sensor. A suitable hole verifier control keeps track of the hole positions in the punch sheet and when the hole position are aligned with the ends of the detector. This allows the punch hole pattern to be checked simultaneously as the adjacent holes are being punched.

In Figs. 4 and 5 there is illustrated a modification of the original punch apparatus of the invention. In this embodiment the punch head 100 contains a plurality of punch elements 32, and the associated elements that make it operate. The multiple punch head is indexed over the sheet workpiece to punch holes as in the previously described punch apparatus. However, with multiple punches in the head, the number of holes that can be punched is greater. Another modification is mounting the punch head 100 on a spider 102 so that the head can be rotated into and out of punching position. The spider permits multiple heads to be mounted for instant use with the workpiece support apparatus. In operation, the punch must be serviced periodically to replace worn punches, etc. A serviced punch head can be held in reserve and rotated into operating position in the event of a malfunction of the head or the need of periodic servicing. This prevents a prolonged shut down of the apparatus. The spider element can be mounted for movement to shift the punch head over the workpiece surface.

The aforedescribed punch apparatus is particularly adapted to punch hole patterns in green ceramic in the production of multi layer ceramic substrates for semiconductor modules of the type described in U.S.-A 4.245.273. In such applications the diameter of the holes is very small, on the order of 125 to 150 microns. The distance between holes varies but can be as close as 250 microns. The ceramic sheet thickness is normally from 200 to 275 microns. In operation, the hole pattern is controlled by a program. The rapidity of the punch stroke is such that the motion of the sheet need not be stopped during the punch stroke. The punch is engaged with the green sheet, i.e. when the punch enters and leaves the sheet for about 10-4 seconds. The sheet support means moves about 250-10 cm during the time interval. This movement is accommodated by the plasticity of the green sheet and possibly a slight flexure of the punch.

Referring now to Fig. 9, there is depicted a schematic diagram of a control means that is part of the punch apparatus of the invention. Processing data, which includes the hole pattern configuration and the amount the pattern must be expanded to compensate for sintering shrinkage of the substrate is transformed into a matrix that is suitable for scanning in the S and Y directions in the punch data process unit 110. A list of hole coordinates is sent to tool control 112 as punch data. Tool control takes the X and Y hole coordinates and generates instructions for moving the X and Y stages 114 that support and move the workpiece sheet to be punched relative to the punch element 32. More specifically, control 112 coordinates the X movement of the table supporting the punch tool 14 and the Y stepping movement of carriage 22. The tool control 112 also generates firing signals for the coil 58 that are coordinated with the instructions for moving the X and Y stages. A punch hole verifier 116 coordinates signals from a photo detector with punch instructions and X and Y stage location data to verify that holes were punched and are clear of debris, etc. The verification, like the punch operation, is accomplished without stopping the continuous movement of the sheet relative to the punch element. the photo detector 118 is responsive to light from light source 120 that passes through a hole in sheet 54 and is conveyed through a fiber optic cable.

In addition, the quality of the holes punched in the green sheet by this apparatus is improved. The green ceramic material has visco elastic properties. When the punch speed is relatively slow it has a tendency to flow about the punch element during the downward punch stroke and subsequently cause sheet distortion. When the punch velocity is very high, as with this punch apparatus, on the order of 10 meters/sec, the green sheet material reacts as if it were brittle material. This results in reduced sheet distortion.

## Claims

1. A programmable punch apparatus (12) for punching hole patterns in thin sheet material (54) including a punch assembly (14), and a punch element (32) mounted on said punch assembly for rectilinear movement relative to thereto, characterized in that it comprises:
a punch element (32) having a lower end of reduced diameter and an upper end,
a collar element (42) of elastic material fixed to said upper end of said punch element (32),
a substantially planar element (40) of highly conductive material mounted on said collar element (42) normal to the direction of said rectilinear movement,
means to dampen the movement of the punch element comprising a flat abutment surface (46) opposed to said planar element (40) on said collar element (42), said abutment surface having an area at least as great as the area of said planar element, the dampening effect being achieved by the momentary entrapment of air between said flat abutment surface and said planar element,
a planar coil (58) fixedly mounted on said punch assembly (14) of said punch apparatus coaxially with said punch element (32) and adjacent to said planar element (40),
carriage means (22) for positioning a thin sheet (54) of material to be punched in the path of said punch element (32), and moving said sheet material in directions transverse to the axis of said punch element,
means (fig. 7) for energizing said coil (58) with a pulse of electrical energy for generating magnetic flux linking with said conductive planar element (40) to repel said planar element from said coil,
an elastic means (34, 42) to rebound said punch element when a hole is performed in said sheet material, and including said collar element (42) and a bushing element (34) of elastic material on said punch assembly that slideably supports said punch element, said collar element (42) and said bushing element (34) being positioned to abut and contact each other after the end of the punch element penetrates said sheet material, and said collar element and said bushing element being formed of hardened steel, for changing the direction of travel of the punch element immediately after the punch end penetrates said sheet material (54),
a spring element (44) concentric about said punch element (32) to hold said planar element (40) against said planar coil (58) between punch operations,
programmable means to selectively move said carriage means in order to specifically locate said sheet relative to said punch element, and to activate said means for energizing said coil to thereby produce a predetermined punched hole pattern in said sheet.

2. The punch apparatus of claim 1 which further includes punch die (52) on said punch assembly (14) that receives the lower end of said punch element (32) upon completion of the punch stroke, and a support means for said sheet material adjacent said punch die, said support means for said sheet material being comprised of at least one first air bearing (82) positioned adjacent said punch die.

3. The punch apparatus of claim 2 which further includes a punch guide block (36) for supporting the lower end of the punch element, at least one second air bearing (84b) in opposed relation to said first air bearing, the combination of said first and said second air bearings adapted in operation to support said sheet material between said punch die and said punch guide block, and includes a plurality of pairs of opposed air bearings located around said punch die (52) and punch guide block (36).

4. The punch apparatus of claim 2 or 3 which further includes a means to verify the integrity of the holes punched in said sheet material (54), said means to verify punched holes being comprised of a light source, a fiber optic cable (94) from said light source to a first support means positioned adjacent said punch die, a light sensor (92), a fiber optic cable (93) from said light sensor to a second support means, said first and second support means being arranged in opposed and aligned relation on opposite sides of said sheet material, the combination of said both support means being capable of sensing the presence or absence of a hole in said sheet material, said programmable means including a means to determine whether or not a hole should exist at given locations, and means to compare the output of said light sensor with the data in said means to determine hole locations.

5. The punch apparatus of claim 2, 3 or 4 which further includes a means to remove a punched slug of sheet material from the lower end of said punch element upon completion of the punch operation, and wherein this means to remove a punched slug of material is comprised of a first closed chamber (90) above a punch guide block (36), a source (84b) of pressurized air connected to said chamber, in operation the withdrawal of said punch element from said punch guide block, following a punching stroke, allowing pressurized air from said chamber to exit through said punch die and hole in said punched sheet material to forceably displace said punched slug potentially lodged in said sheet.

6. The punch apparatus of claim 3, 4 or 5 wherein said means to remove a punch slug of material is further comprised of a second closed chamber (56) beneath said punch die (52), a vacuum source connected to said second closed chamber, in operation, the withdrawal of said punch element from said punch die and sheet material causing air to be drawing through said die and sheet material to forceably remove slugs of material potentially lodged in said sheet.

7. The punch apparatus of any one of the preceding claims wherein said planar coil is comprised of a coil of electrically conductive wire (58A) with spacing means (54B) for maintaining a spacing between the individual wires of the coil, and a means to circulate cooling fluid between the spaced wires of the coil.

8. The punch apparatus of any one of the preceding claims wherein said carriage means (22) is comprised of a pair of spaced rails located adjacent said punch assembly (14), a stage mounted on said rails for movement parallel to said rails, a support for said sheet material mounted on said stage, and means to move said punch assembly (14) in a direction normal to said rails.

9. The punch apparatus of claim 8 wherein said carriage means (22) moves said sheet material in a continuous movement as the punch element is actuated.

10. The punch apparatus of any one of the preceding claims wherein a plurality of punch elements are mounted on said punch assembly (14), and each punch element is separately actuatable (fig. 5).

11. The punch apparatus of claim 10 which further includes spider element (102) with at least two arms as part of said punch assembly, punch elements (32) mounted for rectilinear movement on each arm of said spider, said spider adapted to support a punch element in operative position relative to said carriage means (22), while holding another punch element in reserve.

12. The punch apparatus of any one of the preceding claims wherein said carriage means (22) includes a stage (24, 20) for supporting a sheet of material (54) to be punched that is movable relative to said punch element in a first direction, and a support means (16) for said punch assembly that is movable in a second direction normal to said first direction.

## Patentansprüche

1. Programmierbarer Stanzapparat (12) zum Stanzen von Lochmustern in dünnem Folienmaterial (54) mit einer Stempelanordnung (14), einem Stanzbauteil (32), das auf die besagte Stempelanordnung montiert ist, um die geradlinige Bewegung, bezogen auf die Anordnung, zu gewährleisten, dadurch gekennzeichnet, daß er enthält:
ein Stanzbauteil (32) mit einem unteren Ende mit verringertem Durchmesser und einem oberen Ende,
einem Halsbauteil (42) aus elastischem Material, das am besagten oberen Ende des besagten Stanzbauteils (32) befestigt ist,
einem im wesentlichen ebenen Bauteil (40) aus hochleitendem Material, das auf besagtes Halsbauteil (42) montiert ist, senkrecht zur Richtung der besagten geradlinigen Bewegung,
Mittel für die Dämpfung der Bewegung des Stanzbauteils mit einer flachen Anschlagebene (46), die gegenüber dem besagten ebenen Bauteil (40) auf besagtem Halsbauteil (42) angeordnet ist, wobei die besagte Anschlagebene eine Fläche aufweist, die mindestens so groß ist wie die Fläche des besagten ebenen Bauteils, und der Dämpfungseffekt durch den momentanen Einschluß von Luft zwischen der besagten flachen Anschlagebene und dem besagten ebenen Bauteil erzielt wird,
einer ebenen Spule (58), die fest auf der besagten Stanzanordnung (14) des besagten Stanzapparats koaxial mit dem besagten Stanzbauteil (32) und am besagten ebenen Bauteil (40) anliegend montiert ist,
Fördermittel (22) zum Positionieren einer dünnen Folie (54) von zu stanzendem Material im Weg des besagten Stanzbauteils (32) und Bewegung der besagten Folie in Richtungen quer zur Achse des besagten Stanzbauteils,
Mittel (Abb. 7) zur Versorgung der besagten Spule (58) mit einem Impuls elektrischen Stroms zur Erzeugung eines magnetischen Flusses, in Verbindung mit besagtem leitenden ebenen Bauteil (40), um das besagte ebene Bauteil von der besagten Spule abzustoßen,
ein elastisches Mittel (34, 42), um das besagte Stanzbauteil zurückzustoßen, wenn ein Loch in dem besagten Folienmaterial erzeugt wurde, und zusammen mit dem besagten Halsbauteil (42) und einem Lager (34) aus elastischem Material auf besagter Stanzanordnung, das besagtes Stanzbauteil gleitfähig hält, wobei das besagte Halsbauteil (42) und das besagte Lagerbauteil (34) so positioniert sind, daß sie, nachdem das Ende des Stanzbauteils in das besagte Folienmaterial eingedrungen ist, miteinander in Berührung kommen, und besagtes Halsbauteil und besagtes Lagerbauteil aus gehärtetem Stahl gebildet sind, um die Wegrichtung des Stanzbauteils zu wechseln, unmittelbar nachdem das Ende des Stanzbauteils in das besagte Folienmaterial (54) eingedrungen ist,
ein Federbauteil (44), konzentrisch um besagtes Stanzbauteil (32) angeordnet, um das besagte ebene Bauteil (40) zwischen den Stanzvorgängen gegen die besagte ebene Spule (58) zu halten,
programmierbare Mittel, um besagte Fördermittel selektiv zu bewegen, um die besagte Folie spezifisch am besagten Stanzbauteil zu halten, und um besagte Mittel zu aktivieren, um besagte Spule mit Strom zu versorgen und dadurch ein vorgegebenes Stanzlochmuster in der besagten Folie zu erzeugen.

2. Stanzgerät gemäß Anspruch 1, das ferner eine Grundplatte (52) auf besagter Stanzanordnung (14) enthält, die das untere Ende des besagten Stanzbauteils (32) aufnimmt, wenn der Stanzweg durchlaufen ist, und Haltemittel für das am besagten Stanzstempel anliegende Folienmaterial, wobei die Haltemittel für das besagte Folienmaterial aus mindestens einem ersten Luftlager (82) bestehen, das an der besagten Grundplatte anliegend positioniert ist.

3. Stanzgerät gemäß Anspruch 2, das ferner einen Stempelführungsblock (36) enthält, der das untere Ende des Stanzbauteils trägt, und mindestens ein zweites Luftlager (84b), dem besagten ersten Luftlager gegenüber angeordnet, wobei die Kombination des besagten ersten und des besagten zweiten Luftlagers im Betrieb darauf abgestimmt ist, das besagte Folienmaterial zwischen der besagten Grundplatte und dem besagten Stempelführungsblock zu halten, und mehrere Paare einander gegenüber angeordneter Luftlager um besagte Grundplatte (52) und um den Stempelführungsblock (36) herum enthält.

4. Stanzgerät gemäß Anspruch 2 oder 3, das ferner ein Mittel enthält, um die Vollständigkeit der in besagtes Folienmaterial (54) gestanzten Löcher nachzuprüfen, wobei das besagte Mittel der Überprüfung der gestanzten Löcher eine Lichtquelle, ein Lichtleitfaserkabel (94) von besagter Lichtquelle bis zu einem ersten Trägermittel, das unmittelbar neben der besagten Grundplatte angeordnet ist, einen Lichtsensor (92), ein Lichtleitfaserkabel (93) von besagtem Lichtsensor an ein zweites Trägermittel enthält, wobei das besagte erste und zweite Trägermittel einander gegenüber zu beiden Seiten des besagten Folienmaterials ausgerichtet angeordnet sind, und die Kombination der besagten beiden Halterungsmittel fähig ist, die Anwesenheit oder Abwesenheit eines Loches in besagtem Folienmaterial festzustellen, und besagte programmierbare Mittel ein Mittel enthalten, mit dem festzustellen ist, ob ein Loch an gegebenen Stellen vorhanden sein soll oder nicht, und Mittel, um den Ausgang des besagten Lichtsensors mit den Daten in besagten Mitteln für die Bestimmung der Lochstellen zu vergleichen.

5. Stanzgerät gemäß Anspruch 2, 3 oder 4, das ferner ein Mittel enthält, einen aus dem Folienmaterial ausgestanzten Stift vom unteren Ende des besagten Stanzbauteils nach Beendigung des Stanzvorgangs zu entfernen, und in dem dieses Mittel, den ausgestanzten Teil des Materials zu entfernen, aus einer ersten geschlossenen Kammer (90) über einem Stanzführungsblock (36) und aus einer an besagte Kammer angeschlossenen Druckluftquelle (84b) besteht, wobei im Betrieb bei dem Rückzug des besagten Stanzbauteils vom besagten Stanzführungsblock Druckluft aus der besagten Kammer durch die besagte Grundplatte und das Loch im besagten Folienmaterial gelassen wird, um den potentiell in der besagten Folie befindlichen Stanzrest herauszudrängen.

6. Stanzgerät gemäß Anspruch 3, 4 oder 5, in dem besagtes Mittel für die Entfernung des Stanzrestes des Materials ferner eine zweite geschlossene Kammer (56) unter der besagten Grundplatte (52) und eine an die zweite geschlossene Kammer angeschlossene Vakuumquelle enthält, wobei im Betrieb der Rückzug des besagten Stanzbauteils von der besagten Grundplatte und aus dem Folienmaterial den Durchfluß von Luft durch die besagte Grundplatte und das Folienmaterial bewirkt, um die möglicherweise im Material befindlichen Reste herauszudrücken.

7. Stanzgerät gemäß einem der vorangehenden Ansprüche, in dem die besagte ebene Spule aus einer Spule elektrisch leitenden Drahtes (58A) besteht, mit Abstandsmitteln (54B), die einen Abstand zwischen den einzelnen Windungen der Spule halten, und ein Mittel für den Umlauf von Kühlmedium zwischen den in Anstand gehaltenen Windungen der Spule.

8. Stanzgerät gemäß einem der vorangehenden Ansprüche, in dem besagtes Trägermittel (22) aus einem Paar in Abstand gehaltener Schienen neben besagter Stanzanordnung (14) besteht, sowie aus einer auf besagten Schienen montierter Bühne für die parallel zu den besagten Schienen laufende Bewegung, einer Halterung für das auf der besagten Bühne montierte Folienmaterial, und Mittel für die Bewegung der besagten Stanzanordnung (14) in einer Richtung senkrecht zu den besagten Schienen.

9. Stanzgerät gemäß Anspruch 8, in dem das besagte Trägermittel (22) das besagte Folienmaterial in einer kontinuierlichen Bewegung bewegt, wenn das Stanzbauteil betätigt wird.

10. Stanzgerät gemäß einem der vorangehenden Ansprüche, in dem eine Mehrzahl Stanzbauteile auf besagter Stanzanordnung (14) zusammengefaßt sind, und jedes Stanzbauteil getrennt betätigt werden kann (Abb. 5).

11. Stanzgerät gemäß Anspruch 10, in dem ferner ein spinnenförmiges Bauteil (102) enthalten ist, das mindestens zwei Arme als Bestandteil der besagten Stanzanordnung besitzt, wobei die Stanzbauteile (32) für die geradlinige Bewegung auf jedem Arm der besagten Spinne angeordnet sind, und besagte Spinne so ausgelegt ist, daß sie ein Stanzbauteil in Arbeitsposition bezogen auf das besagte Trägermittel (22) halten kann, während sie ein anderes Stanzbauteil in Reserve hält.

12. Stanzgerät gemäß einem der vorangehenden Ansprüche, in dem das besagte Trägermittel (22) eine Bühne (24, 20) enthält, die eine zu stanzende Materialfolie (54) enthält, die sich in bezug auf das besagte Stanzbauteil in einer ersten Richtung bewegen läßt, und ein Halterungsmittel (16) für die besagte Stanzanordnung, das sich in einer zweiten Richtung senkrecht zur besagten ersten Richtung bewegen läßt.

## Revendications

1. Appareil de perforation programmable (12) pour perforer des configurations de trous dans du matériau en feuille mince (54) comprenant un ensemble de perforation (14) et un élément de perforation (32) monté sur ledit ensemble de perforation pour être animé d'un mouvement rectiligne par rapport à celui ci, caractérisé en ce qu'il comprend:
- un élément de perforation (32) présentant une extrémité inférieure de diamètre réduit et une extrémité supérieure,
- un collier (42) de matière élastique fixé à ladite extrémité supérieure dudit élément de perforation (32),
- un élément pratiquement plan (40) de matériau hautement conducteur monté sur ledit collier (42) normalement à la direction dudit mouvement rectiligne,
- des moyens pour amortir le mouvement dudit élément de perforation comprenant une surface de butée plate (46) opposée audit élément plan (40) sur ledit collier (42), ladite surface de butée étant au moins égale à la surface dudit élément plan, l'effet amortisseur étant assuré par l'emprisonnement momentané de l'air entre ladite surface de butée plate et ledit élément plan,
- un enroulement plan (58) monté fixe sur ledit ensemble de perforation (14) dudit appareil de perforation, co-axialement avec ledit élément de perforation (32) et adjacent audit élément plan (40),
- des moyens à chariots (22) pour placer une feuille mince (54) de matériau à perforer sur la trajectoire dudit élément de perforation (32) et pour déplacer ledit matériau en feuille dans des directions transversales à l'axe dudit élément de perforation,
- des moyens (figure 7) pour exciter ledit enroulement (58) avec une impulsion d'énergie électrique pour générer un flux magnétique couplé audit élément plan conducteur (40) pour repousser ledit élément plan par rapport audit enroulement,
- un moyen élastique (34, 42) pour renvoyer ledit élément de perforation lorsqu'un trou est exécuté dans ledit matériau en feuille, et un manchon (34) de matériau élastique sur ledit ensemble de perforation, dans lequel ledit élément de perforation est monté coulissant, ledit collier (42) et ledit manchon (34) étant positionnés pour venir en butée l'un contre l'autre après que ledit élément de perforation ait fini de pénétrer dans ledit matériau en feuille, ledit collier et ledit manchon étant composé d'acier trempé, afin d'inverser la direction du déplacement de l'élément de perforation immédiatement après la pénétration de l'extrémité de l'élément de perforation dans ledit matériau en feuille (54),
- un ressort (44) disposé concentriquement audit élément de perforation (32) pour retenir ledit élément plan (40) contre ledit enroulement plan (58) entre les opérations de perforation,
- des moyens programmables pour déplacer sélectivement lesdits moyens à chariots afin de disposer de manière précise ladite feuille par rapport audit élément de perforation et activer lesdits moyens pour exciter ledit enroulement afin de réaliser ainsi une configuration de trous perforés prédéterminée dans ladite feuille.

2. L'appareil de perforation selon la revendication 1 qui comprend en outre une matrice de perforation (52) sur ledit ensemble de perforation (14) qui reçoit l'extrémité inférieure dudit élément de perforation (32) à la fin de la course de l'élément de perforation, et un moyen de support dudit matériau en feuille dans une position adjacente à ladite matrice de perforation, ledit moyen de support dudit matériau en feuille étant composé d'au moins un premier palier pneumatique (82) adjacent à ladite matrice de perforation.

3. L'appareil de perforation selon la revendication 2 qui comprend en outre un bloc de guidage de perforation (36) pour guider l'extrémité inférieure de l'élément de perforation, au moins un second palier pneumatique (84b) en relation opposée avec ledit premier palier pneumatique, la combinaison desdits premier et second paliers pneumatiques étant prévue en fonctionnement pour maintenir ledit matériau en feuille entre ladite matrice de perforation et ledit bloc de guidage de perforation, et comprend une pluralité de paires de paliers pneumatiques opposés disposés autour de ladite matrice de perforation (52) et du bloc de guidage de perforation (36).

4. L'appareil de perforation selon la revendication 2 ou 3 qui comprend en outre un moyen de vérifier l'intégrité des trous perforés dans ledit matériau en feuille (54), ledit moyen de vérification des trous perforés étant composé d'une source lumineuse, d'un câble de fibre optique (94) raccordant ladite source lumineuse à un premier moyen de support disposé adjacent à ladite matrice de perforation, un détecteur de lumière (92), un câble de fibre optique (93) raccordant ledit détecteur de lumière à un second moyen de support, lesdits premier et second moyens de support étant agencés en relation opposée et alignée sur les côtés opposés dudit matériau en feuille, la combinaison desdits deux moyens de support étant capable de détecter la présence ou l'absence d'un trou dans ledit matériau en feuille, lesdits moyens programmables comprenant un moyen pour déterminer si oui ou non un trou devrait exister à des emplacements donnés et des moyens pour comparer la sortie dudit détecteur de lumière aux données contenues dans lesdits moyens pour déterminer les emplacements des trous.

5. L'appareil de perforation selon la revendication 2, 3 ou 4 qui comprend en outre un moyen pour retirer un morceau découpé de matériau en feuille de l'extrémité inférieure dudit élément de perforation à la fin de l'opération de perforation et dans lequel ce moyen de retrait d'un morceau de matériau découpé est composé d'une première chambre fermée (90) au dessus d'un bloc de guidage de perforation (36), d'une source (84b) d'air comprimé raccordée à ladite chambre, en fonctionnement, le retrait dudit élément de perforation dudit bloc de guidage de perforation, à la fin d'une course de perforation, permettant à l'air comprimé de ladite chambre de sortir au travers de ladite matrice de perforation et du trou dans ledit matériau en feuille perforé pour déplacer en force ledit morceau découpé potentiellement logé dans ladite feuille.

6. L'appareil de perforation selon la revendication 3, 4 ou 5 dans lequel ledit moyen pour retirer un morceau de matériau découpé est en outre composé d'une seconde chambre fermée (56) sous ladite matrice de perforation (52), d'une source d'aspiration connectée à ladite seconde chambre fermée, en fonctionnement le retrait dudit élément de perforation de ladite matrice de perforation et dudit matériau en feuille provoquant le passage de l'air au travers de ladite matrice et du matériau en feuille pour retirer en force les morceaux de matériau potentiellement logés dans ladite feuille.

7. L'appareil de perforation selon l'une quelconque des revendications précédentes dans lequel ledit enroulement plan est composé d'un enroulement de fil électriquement conducteur (58A) avec des entretoises (54B) pour maintenir un espacement entre les fils individuels de l'enroulement, et un moyen pour faire circuler du fluide de refroidissement entre les fils espacés de l'enroulement.

8. L'appareil de perforation selon l'une quelconque des revendications précédentes dans lequel lesdits moyens à chariots (22) sont composés d'une paire de rails espacés disposés adjacents audit ensemble de perforation (14), d'une plate-forme montée sur lesdits rails pour se déplacer dans un mouvement parallèle auxdits rails, d'un support pour ledit matériau en feuille installé sur ladite plate-forme et des moyens pour déplacer ledit ensemble de perforation (14) dans une direction normale auxdits rails.

9. L'appareil de perforation selon la revendication 8 dans lequel lesdits moyens à chariots (22) entrainent ledit matériau dans un mouvement continu lorsque ledit élément de perforation est actionné.

10. L'appareil de perforation selon l'une quelconque des revendications précédentes dans lequel une pluralité d'éléments de perforation sont montés sur ledit ensemble de perforation (14) et dans lequel chaque élément de perforation peut être actionné séparément (figure 5).

11. L'appareil de perforation selon la revendication 10 qui comprend en outre l'élément moyeu (102) avec au moins deux bras comme partie dudit ensemble de perforation, des éléments de perforation (32) montés sur chaque bras dudit élément moyeu pour être animés d'un mouvement rectiligne, ledit moyeu étant prévu pour porter un élément de perforation en position fonctionnelle par rapport auxdits moyens à chariots (22) tout en retenant un autre élément de perforation en réserve.

12. L'appareil de perforation selon l'une quelconque des revendications précédentes dans lequel lesdits moyens à chariots (22) comprennent une plateforme (24, 20) pour porter une feuille de matériau (54) à perforer qui est mobile par rapport audit élément de perforation dans une première direction et un moyen de support (16) pour ledit ensemble de perforation qui est mobile dans une seconde direction normale à ladite première direction.
